# EUROPEAN PATENT APPLICATION

(11) **EP 3 461 247 A1**
(43) Date of publication of application: **27.03.2019**
(21) Application number: 16902074.0
(22) Date of filing: 15.06.2016
(51) Int. Cl.: H05K 7/20

(54) **HEAT DISSIPATION METHOD AND TERMINAL**

(30) Priority: 16.05.2016 CN 201610323963
(71) Applicant: ZTE Corporation, Shenzhen, Guangdong 518057 (CN)
(72) Inventor: SUN, Chengwen, Shenzhen City Guangdong 518057 (CN)
(74) Representative: Aipex B.V.
(86) International application number: PCT/CN2016/085821
(87) International publication number: WO 2017/197692

(57) **Abstract**

The invention provides a heat dissipation method and terminal. The heat dissipation method is applied to a terminal (10). The terminal (10) includes a first temperature collector (101) disposed in a first region of a housing (20) of the terminal and a second temperature collector (102) disposed in a second region of the housing (20) of the terminal. The method includes: acquiring (step 201) a current first temperature captured by the first temperature collector (101) and a current second temperature captured by the second temperature collector (102), the first temperature representing the highest temperature of the housing of the terminal and the second temperature representing an environmental temperature of an environment of the terminal; determining (step 202) a current temperature threshold according to the second temperature and a correspondence between the second temperature and a temperature threshold; and adjusting a current operation parameter of the terminal according to a difference between the first temperature and the temperature threshold when the first temperature is greater than the temperature threshold, enabling the terminal to use the adjusted current operation parameter.

## Description

### TECHNICAL FIELD

The present invention relates to the field of communications and to, for example, a heat dissipation method and terminal.

### BACKGROUND

At present, terminals have chips with increasing processing speed and have improving performance. Meanwhile, the heating problem of the terminals is also getting more and more serious.

The heat dissipation methods in the existing art include: transferring heat from an internal chip of a terminal to a housing of the terminal by a heat dissipation material such as a thermal pad, a graphite heat sink and a heat dissipation copper foil to achieve a heal balance on the terminal; or, detecting the temperature of the chip by an thermal sensor in the chip of the terminal, and reducing the processing speed of the chip or limiting a data throughput of the terminal according a preset model when the temperature of the chip exceeds a preset temperature, thereby reducing the temperature of the terminal.

However, the temperature acceptable to terminal users varies with the actual environment of the terminal. The heat dissipation methods in the existing art adopt a single dissipation measure which cannot really lower temperature of the terminal to the temperature acceptable to the users, thereby reducing the heat dissipation performance of the terminal.

### SUMMARY

The following is a summary of the subject matter described in detail in the present invention. This summary is not intended to limit the scope of the claims.

Embodiments of the present invention provide a heat dissipation method and terminal capable of improving the heat dissipation performance of the terminal.

In a first aspect, an embodiment of the present invention provides a heat dissipation method applied to a terminal. The terminal includes a first temperature collector disposed in a first region of a housing of the terminal and a second temperature collector disposed in a second region of the housing of the terminal. The heat dissipation method includes:
when a preset time reaches, acquiring a current first temperature captured by the first temperature collector and a current second temperature captured by the second temperature collector; where first temperature represents a highest temperature of the housing of the terminal and the second temperature represents an environmental temperature of an environment of the terminal.
determining a current temperature threshold according to the second temperature and a preset correspondence between the second temperature and the temperature threshold,; and
adjusting an operation parameter of the terminal according to a difference between the first temperature and the temperature threshold when the first temperature is greater than the temperature threshold , such that the terminal can use the adjusted operation parameter.

Optionally, the step of adjusting the operation parameter of the terminal according to the difference between the first temperature and the temperature threshold includes:
determining an operation parameter of a to-be-operated level according to the difference between the first temperature and the temperature threshold and a correspondence between a preset difference and the operation parameter of each level; and
adjusting from a current operation parameter of the terminal to the operation parameter of the to-be-operated level.

Optionally, after the step of adjusting the operation parameter of the terminal according to the difference between the first temperature and the temperature threshold, the method further includes:
repeating the steps of acquiring, determining and adjusting when a next preset time reaches after adjusting the current operation parameter of the terminal.

Optionally, the first temperature collector includes at least two first temperature sub-collectors. The step of acquiring the current first temperature captured by the first temperature collector includes:
acquiring at least two first candidate temperatures captured by the at least two first temperature sub-collectors when a current preset time reaches; and
taking a maximum of the at least two first candidate temperatures as the first temperature.

Furthermore, the operation parameter of the to-be-operated level includes at least one of:
a to-be-operated charging current value, to-be-operated backlight brightness and a first to-be-operated parameter.

Optionally, the correspondence between the second temperature and the temperature threshold is configured in the following manner:
the correspondence between the second temperature and the temperature threshold is configured based on user behaviors.

In a second aspect, an embodiment of the present invention provides a terminal, which includes: a first temperature collector disposed in a first region of a housing of the terminal, a second temperature collector disposed in a second region of the housing of the terminal and a control chip connected to the first temperature collector and the second temperature collector.

The first temperature collector is configured to acquire a current first temperature when a preset time reaches. The first temperature represents a highest temperature of the housing of the terminal.

The second temperature collector is configured to acquire a current second temperature when the preset time reaches. The second temperature represents an environmental temperature of an environment of the terminal.

The control chip is configured to determine, according to the second temperature and a preset correspondence between the second temperature and a temperature threshold, a corresponding current temperature threshold; adjust, according to a difference between the first temperature and the temperature threshold, an operation parameter of the terminal when the first temperature acquired by the first temperature collector is greater than the temperature threshold.

Optionally, the first region includes a middle position of an inner side of the housing of the terminal. The second region includes an edge position of the inner side of the housing of the terminal. The first temperature collector includes at least two first temperature sub-collectors.

The first temperature collector is configured to acquire, when a preset time reaches, at least two first candidate temperatures acquired by the at least two first temperature sub-collectors, and to take a maximum of the at least two first candidate temperatures as the first temperature.

Optionally, each of the first temperature collector and the second temperature collector is implemented by a thermal sensor. The thermal sensor includes a thermistor and a flexible printed circuit. The flexible printed circuit and the thermistor are connected to the control chip.

Optionally, the terminal further includes an analog-to-digital converter connected to the flexible printed circuit and the control chip.

The thermistor is configured to convert the temperature into an electrical signal.

The flexible printed circuit is configured to transmit the electrical signal to the analog-to-digital converter.

The analog-to-digital converter is configured to convert the electrical signal from an analog quantity to a digital quantity and transmit to the control chip.

The embodiments of the present invention provide a heat dissipation method and terminal. The heat dissipation method is applied to the terminal. The terminal includes the first temperature collector disposed in the first region of the housing of the terminal and the second temperature collector disposed in the second region of the housing of the terminal. The heat dissipation method includes: when the preset time reaches, acquiring the current first temperature acquired by the first temperature collector and the current second temperature acquired by the second temperature collector, the first temperature representing the highest temperature of the housing of the terminal and the second temperature representing the environmental temperature of the environment of the terminal; determining the current temperature threshold according to the second temperature and the preset correspondence between the second temperature and the temperature threshold; and adjusting the current operation parameter of the terminal according to the difference between the first temperature and the temperature threshold when the first temperature is greater than the temperature threshold. It can be seen that in the embodiments of the present invention, the current temperature threshold of the current environmental temperature is determined according to the second temperature (that is, the environmental temperature), so that the terminal may adopt different values of the temperature threshold according to different environmental temperatures to perform the heat dissipation of the terminal. In this way, the terminal may adjust the operation parameter according to the determination according to the values of the temperature threshold in different situations to achieve good heat dissipation, thereby improving the heat dissipation performance of the terminal, and expanding the adaptability of the terminal for heat dissipation in different environmental temperatures.

Other aspects can be understood after the drawings and detailed description are read and understood.

### BRIEF DESCRIPTION OF DRAWINGS

FIG. 1 is a flowchart of a heat dissipation method according to an embodiment of the present invention;
FIG. 2 is a schematic diagram of a first temperature collector and a second temperature collector according to an embodiment of the present invention;
FIG. 3 is chart illustrating the mapping between a second temperature and a temperature threshold according to an embodiment of the present invention;
FIG. 4 is a schematic diagram of an interface for configuration of heat dissipation according to an embodiment of the present invention;
FIG. 5 is a flowchart of a heat dissipation method according to an embodiment of the present invention;
FIG. 6 is a structural diagram of a terminal according to an embodiment of the present invention;
FIG. 7 is a schematic diagram of a housing of a terminal according to an embodiment of the present invention; and
FIG. 8 is a structural diagram of a terminal according to an embodiment of the present invention.

### DETAILED DESCRIPTION

Technical solutions in embodiments of the present invention will be described clearly and completely in conjunction with drawings in the embodiments of the present invention.

### Embodiment 1

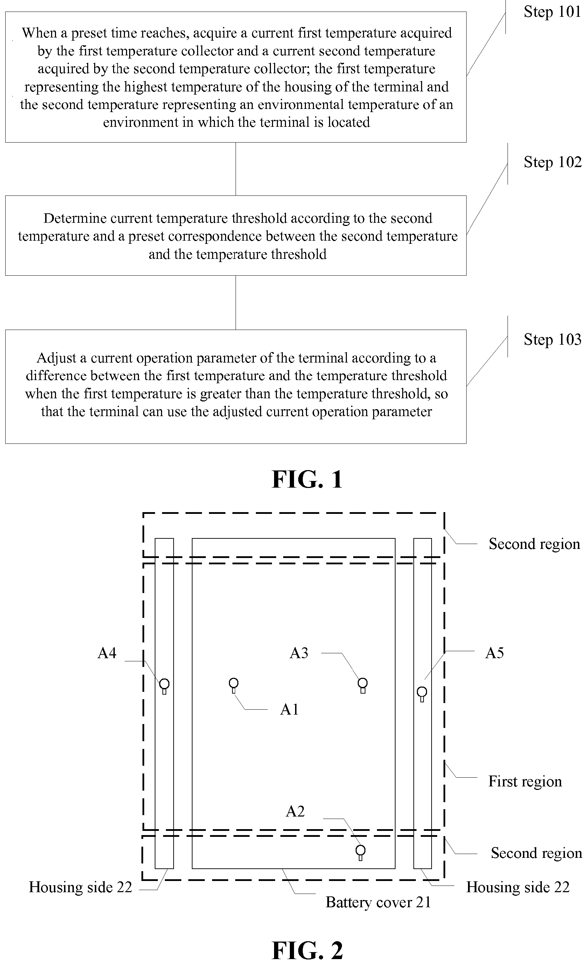

FIG. 1 is a flowchart of a heat dissipation method according to an embodiment of the present invention. The heat dissipation method is applied to the terminal. The terminal includes a first temperature collector disposed in a first region of a housing of the terminal and a second temperature collector disposed in a second region of the housing of the terminal. The heat dissipation method of this embodiment includes step 101, step 102 and step 103.

In step 101, when a preset time reaches, a current first temperature acquired by the first temperature collector and a current second temperature acquired by the second temperature collector are acquired. The first temperature is used for representing the highest temperature of the housing of the terminal and the second temperature is used for representing an environmental temperature of an environment in which the terminal is located.

It is to be noted that the preset time is used for representing a period during which the first temperature acquired by the first temperature collector and the second temperature is captured by the second temperature collector. When the preset time reaches, the terminal acquires the current first temperature and the current second temperature. The preset time may be configured according to actual requirements and is not limited in this embodiment of the present invention.

In some embodiments, the housing of the terminal protects device such as a Printed Circuit Board (PCB) and a battery in the terminal. An inner side of the housing of the terminal faces a mainboard of the terminal. The housing of the terminal includes a battery cover 21 and a housing side 22 (referring to FIG. 2). Heat generated by a chip on a PCB mainboard of the terminal during the operation of the chip may be delivered to the housing of the terminal through a shielding cover, a heat dissipation film and an air layer, etc. The housing of the terminal is held and touched by a terminal user. The temperature that the terminal user directly feels is the heat delivered to the housing of the terminal. Therefore, spaces are reserved for the first temperature collector and the second temperature collector on the housing of the terminal, and the first temperature collector and the second temperature collector are disposed on the first region and the second region of the terminal housing respectively (exemplarily referring to FIG. 2)

The first region of the housing includes a middle position of an inner side of the housing. That is, a position of the housing corresponding to a main heating chip on an internal terminal mainboard is covered, and this position is often touched by the user. Therefore, the temperature of the first region of the housing may be used for representing the temperature of the housing that the user may actually feel. The arrangement of the first region is not limited in the embodiment of the present invention.

The second region of the housing includes an edge position of the inner side of the housing, that is, positions of the top and bottom of the housing when a terminal display screen is placed vertically. Because the regions of the top and bottom of the housing keep away from the heating chip on the internal mainboard of the terminal and are not often touched, the temperature of the second region of the housing is not affected by the heating chip of the terminal and user behaviors, and may be used for representing the environmental temperature of the environment in which the terminal is located. The arrangement of the second region is not limited in the embodiment of the present invention.

In addition, FIG. 2 is merely one example of the positions of the first region and the second region. The first region and the second region may be arranged according to the actual using habits, which is not limited in the embodiment of the present invention.

The first temperature is used for representing the highest temperature of the housing of the terminal, that is, the temperature that the user who operates the terminal feels. It is to be understood that the extremely high temperature of the housing of the terminal affects user experience of the terminal.

The second temperature is used for representing the environmental temperature of the environment in which the terminal is located. However, the environmental temperature of the environment in which the terminal is located is susceptible to the current season and the environment in which the terminal is located. For example, there is a large difference of the environmental temperature between summer and winter or between indoor and outdoor. For different environmental temperatures, the terminal user has different requirements on the temperature of the housing of the terminal. Therefore, it is necessary to detect the environmental temperature of the environment in which the terminal is located, so that the terminal can perform corresponding heat dissipation measures at different environmental temperatures, thereby improving the adaptability for heat dissipation of the terminal at different environmental temperatures.

In practice, the first temperature collector and the second temperature collector are temperature collection systems, thermal sensors, and thermistors, etc., and are not limited in this embodiment of the present invention.

For example, in one implementation mode, each of the first temperature collector and the second temperature collector includes a Negative Temperature Coefficient (NTC) thermistor and a Flexible Printed Circuit (FPC). The FPC is provided with a "goldfinger" connected to a resilient piece on a corresponding position of the mainboard. When the temperature rises, the resistance of this thermistor changes and the corresponding voltage changes. The temperature change is detected based on the conversion relationship between the resistance and the voltage.

Optionally, the step in which the current first temperature captured by the first temperature collector includes: acquiring at least two first candidate temperatures captured by the at least two first temperature sub-collectors when a current preset time reaches; a maximum of the at least two first candidate temperatures is determined; and the maximum of the at least two first candidate temperatures is taken as the first temperature.

The first temperature collector of the terminal includes at least two first temperature sub-collectors.

For example, the first temperature collector includes four first temperature sub-collectors disposed in the first region (referring to FIG. 2): a first temperature sub-collector A1 and a first temperature sub-collector A3 disposed on an inner side of the battery cover of the terminal, as well as a first temperature sub-collector A4 and a first temperature sub-collector A5 separately disposed on inner sides of two housing sides of the terminal. Four first candidate temperatures are acquired by the four first temperature sub-collectors, a maximum first candidate temperature is determined is taken as the first temperature of the terminal.

In addition, the second temperature collector disposed on the second region (referring to FIG. 2) of the terminal is configured to capture the second temperature. The second temperature is used for representing the environmental temperature of the environment in which the terminal is located.

In step 102, a current temperature threshold is determined according to the second temperature and a preset correspondence between the second temperature and the temperature threshold.

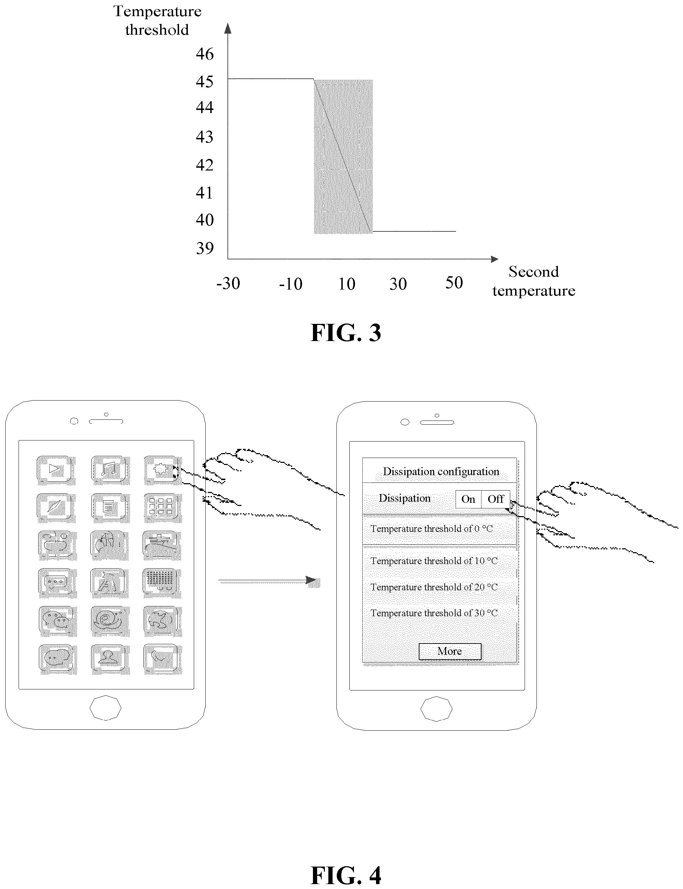

It is to be understood that the terminal user has different requirements on the temperature of the housing at different environmental temperatures, referring to FIG. 3. In FIG. 3, a horizontal axis represents the second temperature, and is used for representing the environmental temperature of the environment in which the terminal is located. A vertical axis represents a temperature threshold corresponding to the second temperature, that is, a maximum temperature of the housing acceptable to the user. That is, the temperature of the housing should not exceed the maximum temperature of the housing acceptable to the user. If the temperature of the housing exceeds the maximum temperature, a terminal heat dissipation processing such as reducing the processing speed of the terminal is required for reducing the heat generated by the terminal, thereby reducing the temperature of the housing of the terminal and achieving heat dissipation of the terminal. The preset correspondence between the second temperature and the temperature threshold means that the temperature threshold is a function of the second temperature.

Referring to FIG. 3, if the second temperature of the terminal is 30 degrees, the temperature threshold corresponding to the second temperature is 40 degrees. If the second temperature is 5 degrees, the temperature threshold corresponding to the second temperature is 45 degrees. When the second temperature is 30 degrees and the first temperature exceeds 40 degrees of the temperature threshold, the terminal may reduce the temperature of the housing by reducing the performance of the Central Processing Unit (CPU) and Graphics Processing Unit (GPU) of the terminal. When the terminal detects that the second temperature is 5 degrees and the first temperature exceeds the temperature threshold of 45 degrees, the terminal may reduce the temperature of the housing by reducing the performance of CPU and GPU of the terminal.

In addition, the terminal may preset the correspondence between the second temperature and the temperature threshold by referring to International Electrotechnical Commission (IEC) regulations with reference to table 1.

**Table 1: Reference range of the temperature threshold**

| Touched part of terminal | Highest temperature °C | | |
|---|---|---|---|
| | Metal | Glass and Ceramic | Plastic and Rubber |
| Handle and knob touched for a short time | 60 | 70 | 85 |
| Handle and knob touched continuously in normal use | 55 | 65 | 75 |
| External surface possibly touched of the terminal | 70 | 80 | 95 |
| Internal components possibly touched of the terminal | 70 | 80 | 95 |

Optionally, the configuration of the correspondence between the second temperature and the temperature threshold includes configuration of the correspondence between the second temperature and the temperature threshold based on user behaviors.

Optionally, as shown in FIG. 4, the users may open a configuration interface of the terminal to configure the correspondence between the temperature and the temperature threshold in options of heat dissipation configuration. For example, when the temperature is 30 degrees, the corresponding temperature threshold is configured to 40 degrees according to the requirement of the user.

Of course, the correspondence between the second temperature and the temperature threshold may also be configured in other manners according to actual requirements in this embodiment of the present invention.

In step 103, a current operation parameter of the terminal is adjusted according to a difference between the first temperature and the temperature threshold when the first temperature is greater than the temperature threshold, so that the terminal can use the adjusted current operation parameter.

The terminal presets the current operation parameter according to the difference between the first temperature and the temperature threshold. When the terminal runs different applications, such as call, charging, data internet, Wireless-Fidelity (WIFI) video and game, heating situations of the terminal, that is, values of the first temperature, are different. Therefore, the terminal may configure the current operation parameter of the terminal according to the difference between the first temperature and the temperature threshold in conjunction with a current running application, so that the terminal can reduce the temperature of the housing of the terminal to the temperature threshold corresponding to the environmental temperature by corresponding heat dissipation measures. In addition, the terminal may recognize the current opening application of the terminal by using a scenario model recognition system.

For example, when the terminal is communicating, the current operation parameter of the terminal adjusted by the terminal according to the difference between the first temperature and the temperature threshold is a current radio-frequency power of the terminal. If the difference between the first temperature and the temperature threshold is a first-level difference, a corresponding amount to be adjusted on the current radio-frequency power of the terminal is 5% of a preset radio-frequency power. If the difference between the first temperature and the temperature threshold is a second-level difference, the corresponding amount to be adjusted on the current radio-frequency power of the terminal is 10% of the preset radio-frequency power. If the difference between the first temperature and the temperature threshold is a third-level difference, the corresponding amount to be adjusted on the current radio-frequency power of the terminal is 15% of the preset radio-frequency power. In this way, the amount to be adjusted at different levels on the operation parameter are obtained according to the difference between the first temperature and the temperature threshold by the terminal, thereby achieving grading heat dissipation of the terminal and improving the heat dissipation performance of the terminal. The correspondence of the difference between the first temperature and the temperature threshold to the amount to be adjusted on the current operation parameter configured by the terminal is not limited in this embodiment of the present invention.

Optionally, the step in which the current operation parameter of the terminal is adjusted according to the difference between the first temperature and the temperature threshold includes: determining the operation parameter of a to-be-operated level according to the difference between the first temperature and the temperature threshold, as well as a correspondence between a preset difference and the operation parameter of each level; and adjusting the current operation parameter of the terminal to the operation parameter of the to-be-operated level.

It is to be noted that the correspondence between the preset difference and the operation parameter of each level enables the terminal to achieve the grading heat dissipation by using the operation parameter of different levels according to the difference of the difference between the first temperature and the temperature threshold. The configuration of the correspondence between the difference and the operation parameter of each level is not limited in this embodiment of the present invention.

Optionally, the operation parameter of a to-be-operated level includes at least one of a to-be-operated charging current value, to-be-operated backlight brightness and a first to-be-operated parameter.

The first to-be-operated parameter includes a to-be-operated radio-frequency power, a to-be-operated wording frequency of a Central Processing Unit (CPU) and a to-be-operated working frequency of a Graphic Processing Unit (GPU).

For example, the parameter of the to-be-operated level determined by the terminal according to the difference between the first temperature and the temperature threshold is a first charging current value or a first radio-frequency power. It is to be noted that the current running application of the terminal may be one application or multiple applications. For example, when the terminal is communicating, in order to ensure the normal communication between the terminal and a base station, a radio-frequency power amplifier increases a transmit power. In this case, the terminal reduces the radio-frequency power of the radio-frequency power amplifier (that is, a current radio-frequency power of the terminal is adjusted into the first radio-frequency power) to achieve the heat dissipation of the terminal. If the terminal is communicating while charging, the terminal further adjust a current charging current value of the terminal to the first charging current value (that is, reducing the charge current value) to achieve further heat dissipation of the terminal.

In practice, the operation parameter of the to-be-operated level includes working parameters of various application software and function modules of the terminal, such as current backlight brightness of a Liquid Crystal Display (LCD) of the terminal, a current WIFI data throughput of the terminal, a current working frequency of a CPU of the terminal and a current working frequency of a GPU of the terminal.

It is to be understood that current running application software of the terminal may include multiple applications, such as call, high speed data transmission, WIFI video transmission and game scenario. The terminal may gradingly adjust working parameters of high power consumption components of various modules by a heating control system of the terminal according to different levels of operation parameters. In this way, system performance and user experience of the terminal may be both fully taken into account.

For example, if the parameter of the to-be-operated level determined by the terminal is the to-be-operated charging current value and the to-be-operated backlight brightness, the terminal performs the heat dissipation by adjusting current backlight brightness to the to-be-operated backlight brightness, and adjusting a current charging current value to the to-be-operated charging current value. When a next preset time reaches, the terminal determines that the first temperature is still greater than the temperature threshold based on a current real-time temperature acquired, then the terminal further adjusts a current radio-frequency power of the radio-frequency power amplifier to the to-be-operated radio-frequency power while adjusting the current backlight brightness and the current charge current value, thereby improving the heat dissipation performance of the terminal. It can be seen that for the heat dissipation process in each preset time period, because the current first temperature, the temperature threshold and the parameter of the to-be-operated level may be different, the terminal gradually achieves grading heat dissipation of the terminal according to the parameters of different to-be-operated level.

Optionally, after the step in which the current operation parameter of the terminal is determined according to the difference between the first temperature and the temperature threshold, the method further includes: executing next heat dissipation process when a next preset time reaches after adjusting the current operation parameter of the terminal.

The heat dissipation process includes steps 101 to 103, that is, when the next preset time reaches, the terminal repeats the steps 101 to 103 to execute the next heat dissipation process by adopting a real-time temperature acquired at this time (a current temperature).

It is to be noted that in each heat dissipation process executed by the terminal, because the current first temperature, the temperature threshold and the parameter of the to-be-operated level may be different, the terminal gradually achieves grading heat dissipation of the terminal by the parameter of different to-be-operated levels. In addition, the terminal cyclically executes the heat dissipation process until the current first temperature is less than or equal to the corresponding temperature threshold of the terminal. Then the terminal maintains the current operation parameter and stops executing the heat dissipation process.

### Embodiment 2

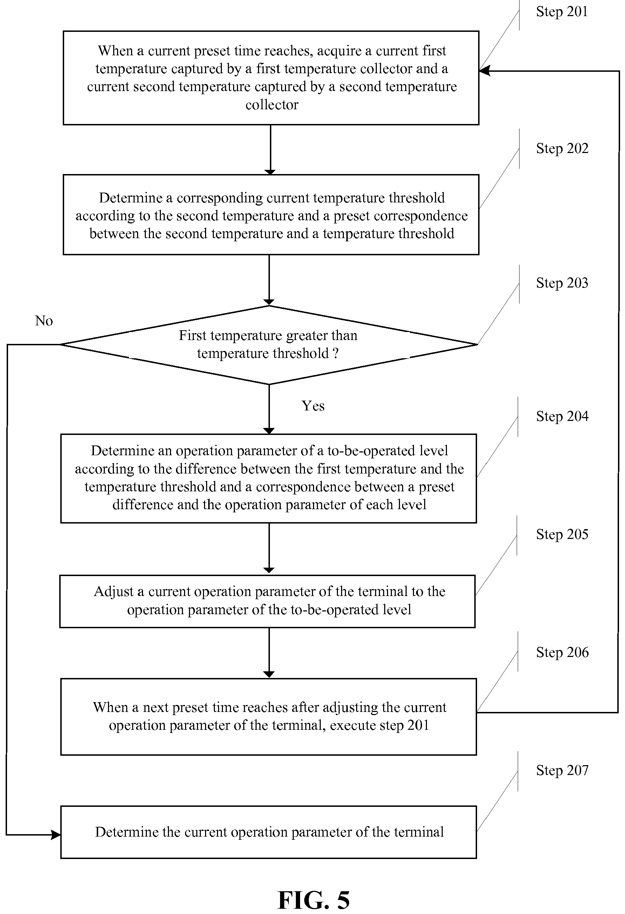

FIG. 5 is a flowchart of a heat dissipation method according to an embodiment of the present invention. The method includes steps 201 to 207.

In step 201, when a current preset time reaches, a current first temperature captured by a first temperature collector and a current second temperature captured by a second temperature collector are acquired.

The first temperature is used for representing the highest temperature of the housing of the terminal. The second temperature is used for representing an environmental temperature of an environment in which the terminal is located.

In step 202, a corresponding current temperature threshold is determined according to the second temperature and a preset correspondence between the second temperature and a temperature threshold.

It is to be noted that the terminal may configure, according to user behaviors, the correspondence between the second temperature and the temperature threshold.

In step 203, whether the first temperature is greater than the temperature threshold is determined; if the first temperature is greater than the temperature threshold, the process goes into step 204; if the first temperature is not greater than the temperature threshold, the process goes into step 207.

In step 204, an operation parameter of a to-be-operated level is determined according to the difference between the first temperature and the temperature threshold and a correspondence between a preset difference and the operation parameter of each level.

The operation parameter of the to-be-operated level includes at least one of a to-be-operated charging current value, to be operated backlight brightness and a first to-be-operated parameter. The first to-be-operated parameter includes a to-be-operated radio-frequency power, a to-be-operated working frequency of a CPU and a to-be-operated working frequency of a GPU.

In step 205, a current operation parameter of the terminal is adjusted to the operation parameter of the to-be-operated level.

It can be seen that for the heat dissipation process in each preset time period, because the current first temperature and the current temperature threshold of the terminal may be different, then, the corresponding operation parameter of the to-be-operated level may also be different, so that the terminal achieves grading heat dissipation of the terminal by using the parameter of different to-be-operated levels, thereby improving the heat dissipation performance of the terminal.

In step 206, when a next preset time reaches after adjusting the current operation parameter of the terminal, the step 201 is executed.

Here, in each heat dissipation process executed by the terminal, because the current first temperature, the temperature threshold and the parameter of the to-be-operated level may be different, the terminal gradually achieves grading heat dissipation of the terminal by using the parameter of different to-be-operated levels. In addition, the terminal cyclically executes the heat dissipation process until the current first temperature is less than or equal to the corresponding temperature threshold of the terminal. Then the terminal maintains the current operation parameter and stops executing the heat dissipation process.

In step 207, the current operation parameter of the terminal is maintained.

In conclusion, the embodiments of the present invention provide a heat dissipation method and a terminal. The heat dissipation method is applied to a terminal. The terminal includes a first temperature collector disposed in a first region of a housing of the terminal and a second temperature collector disposed in a second region of the housing of the terminal. The method includes: when a current preset time reaches, acquiring a current first temperature captured by the first temperature collector and a current second temperature captured by the second temperature collector, the first temperature representing the highest temperature of the housing of the terminal and the second temperature representing an environmental temperature of an environment of the terminal; determining a current temperature threshold according to a the second temperature as well as a preset correspondence between the second temperature and a temperature threshold; and adjusting a current operation parameter of the terminal according to a difference between the first temperature and the temperature threshold when the first temperature is greater than the temperature threshold. It can be seen that in the embodiments of the present invention, the current temperature threshold of the current environmental temperature is determined according to the second temperature, that is, the environmental temperature, so that the terminal may adopt different values of the temperature threshold according to different environmental temperatures to perform the heat dissipation of the terminal. In this way, the terminal may adjust the current operation parameter according to the determination based on the values of the temperature threshold in different situations to achieve good heat dissipation, thereby improving the heat dissipation performance of the terminal, and expanding the adaptability of the terminal for heat dissipation at different environmental temperatures.

### Embodiment 3

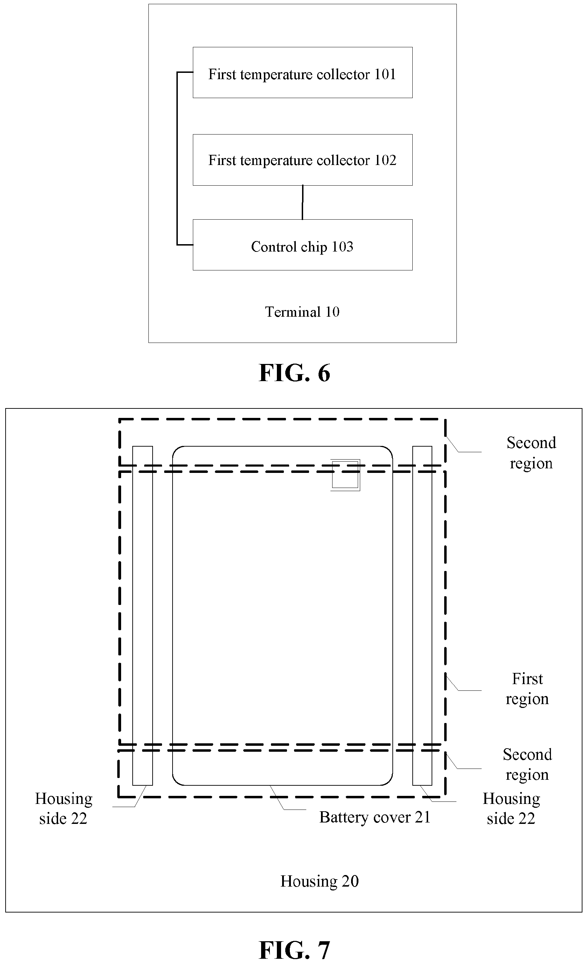

FIG. 6 is a structural diagram of a terminal according to an embodiment of the present invention. The terminal 10 includes: a first temperature collector 101 disposed in a first region of the housing of the terminal, a second temperature collector 102 disposed in a second region of the housing of the terminal 10 and a control chip 103 connected to the first temperature collector 101 and the second temperature collector 102.

The first temperature collector 101 is configured to acquire a current first temperature when the preset time reaches. The first temperature is used for representing the highest temperature of the housing of the terminal 10.

The second temperature collector 102 is configured to acquire a current second temperature when the preset time reaches. The second temperature is used for representing an environmental temperature of an environment in which the terminal is located.

The control chip 103 is configured to determine a corresponding current temperature threshold according to the second temperature acquired by the second temperature collector 102 and a correspondence between the second temperature and the temperature threshold; adjust, according to a difference between the first temperature and the temperature threshold, an operation parameter of the terminal 10 when the first temperature captured by the first temperature collector 101 is greater than the temperature threshold.

Optionally, the first region includes a middle position of an inner side of the housing in the terminal 10. The second region includes an edge position of the inner side of the housing in the terminal 10. The middle position of the inner side of the housing of the terminal 10 and the edge position of the inner side of the housing of the terminal belong to different positions. The first temperature collector 101 includes at least two first temperature sub-collectors. The first temperature collector 101 is configured to acquire, when a current preset time reaches, at least two first candidate temperatures captured by the at least two first temperature sub-collectors disposed on the terminal 10, and to determine a maximum of the at least two first candidate temperatures, and take the maximum of the at least two first candidate temperatures as the first temperature.

FIG. 7 is a schematic diagram of a housing of the terminal according to an embodiment of the present invention. Referring to FIG. 7, the housing 20 includes a battery cover 21 and a housing side 22. The housing 20 is configured to protect a Printed Circuit Board (PCB) mainboard and a terminal battery of the terminal. An inner side of the housing 20 faces a terminal mainboard. Heat generated by a operating chip on the terminal PCB mainboard may be delivered to the housing 20 through a shielding cover, a heat dissipation film and an air layer, etc. The housing 20 is held and touched by the terminal user. The temperature that the terminal user directly feel is the heat delivered to the housing 20. Therefore, space may be reserved on the housing for the first temperature collector and the second temperature collector, and the first temperature collector and the second temperature collector are disposed on the first region and the second region of the housing 20 respectively (as shown in FIG. 7), and is not limited in this embodiment of the present disclosure.

It is to be understood that the first region (as shown in FIG. 7) includes a middle position of an inner side of the housing 20 of the terminal 10. That is, a position of the housing 20 corresponding to a main heating chip on an internal mainboard of the terminal, and the position is often touched by the user. Therefore, the temperature of the first region of the housing 20 may be used for representing the temperature of the housing 20 that the users may actually feel. Of course, the arrangement of the second region is not limited in this embodiment of the present invention.

The second region (as shown in FIG. 7) includes an edge position of the inner side of the housing 20 of the terminal 10, that is, positions of the top and bottom of the housing 20 when a display screen of the terminal is placed vertically. Because the regions of the top and bottom of the housing keeps away from the heating chip on the internal mainboard of the terminal, and this position is not often touched by the user, the temperature of the second region of the housing 20 is not affected by the internal heating chip of the terminal and user behaviors, and may be used for representing the environmental temperature of the environment in which the terminal is located. The arrangement of the second region is not limited in the embodiment of the present invention.

In addition, referring to FIG. 2, the first temperature collector includes four first temperature sub-collectors: a first temperature sub-collector A1 and a first temperature sub-collector A3 disposed on an inner side of the battery cover 21 of the terminal, as well as a first temperature sub-collector A4 and a first temperature sub-collector A5 separately disposed on inner sides of two housing sides 22 of the terminal. Four first candidate temperatures are acquired by the four first temperature sub-collectors, a maximum first candidate temperature is determined taken as the first temperature of the terminal. The second temperature collector A2 is disposed on the bottom of the battery cover 21 of the terminal, and the second temperature collector A2 is used for capturing the second temperature. The second temperature is used for representing the environmental temperature of the environment in which the terminal is located.

Optionally, each of the first temperature collector 101 and the second temperature collector 102 is implemented by a thermal sensor. The thermal sensor includes a thermistor 104 and a flexible printed circuit 105. The flexible printed circuit 105 and the thermistor 104 are connected to the control chip 103.

The flexible printed circuit 105 is provided with a goldfinger connected to a resilient piece on a corresponding position of the mainboard. When the temperature changes, the resistance of the thermistor 104 changes, so that a voltage obtained at a sampling port of the control chip 103 changes, and the temperature change is detected by the conversion relationship between the resistance and the voltage.

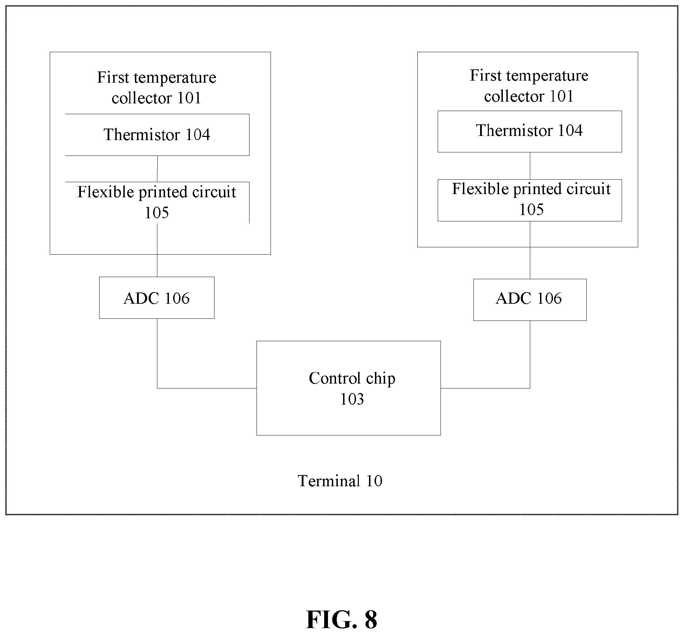

Optionally, referring to FIG. 8, the terminal 10 further includes an analog-to-digital converter 106 connected between the flexible printed circuit 105 and the control chip 103.

The thermistor 104 is configured to convert the temperature into an electrical signal.

The flexible printed circuit 105 is configured to transmit the electrical signal to the analog-to-digital converter 106.

The analog-to-digital converter 106 is configured to convert the electrical signal from analog quantity to digital quantity and transmit to the control chip 103.

It is to be noted that the terminal in this embodiment of the present invention includes a smart phone, a smart TV and a Tablet PC, etc.

It is to be understood by those skilled in the art that the embodiments of the present invention may be provided as methods, systems and computer program products. Therefore, the present invention may adopt a mode of a hardware embodiment, a software embodiment, or a combination of hardware and software embodiment. In addition, the present invention may adopt the form of a computer program product implemented in one or more computer-usable storage media (including, but not limited to, a disk memory and an optical memory) that includes computer-usable program codes.

The present invention is described with reference to flowcharts and/or block diagrams of methods, apparatuses (systems) and computer program products according to the embodiments of the present invention. It should be understood that computer program instructions implement each flow and/or block in the flowcharts and/or block diagrams and a combination of flows and/or blocks in the flowcharts and/or block diagrams. These computer program instructions may be provided to a general-purpose computer, a special-purpose computer, an embedded processor or a processor of another programmable data processing apparatus to produce a machine so that instructions executed by a computer or a processor of another programmable data processing apparatus produce a means for implementing the functions specified in one or more flows in the flowcharts and/or one or more blocks in the block diagrams.

These computer program instructions may also be stored in a computer-readable memory which can direct a computer or another programmable data processing apparatus to operate in a particular manner so that the instructions stored in the computer-readable memory produce a manufactured product including an instruction device. The instruction device implements the functions specified in one or more flows in the flowcharts and/or one or more blocks in the block diagrams.

These computer program instructions may also be loaded onto a computer or another programmable data processing apparatus so that a series of operation steps are performed on the computer or another programmable apparatus to produce processing implemented by a computer. Therefore, instructions executed on a computer or another programmable apparatus provide steps for implementing the functions specified in one or more flows in the flowcharts and/or one or more blocks in the block diagrams.

The above are only preferred embodiments of the present invention and are not intended to limit the scope of the present invention.

It is to be noted that the terms "first", "second" and the like in the description, claims and above accompanying drawings of the present disclosure are used to distinguish between similar objects and are not necessarily used to describe a particular order or sequence.

From the description of the embodiments described above, it will be apparent to those skilled in the art that the method of any embodiment described above may be implemented by means of software plus a necessary general-purpose hardware platform, or may of course be implemented by hardware. Based on this understanding, the technical solutions provided by the present invention may be embodied in the form of software products. The computer software products are stored in a storage medium (such as a ROM/RAM, a magnetic disk or an optical disk) and include instructions for enabling a terminal device (which may be a mobile phone, a computer, a server, an air-conditioner or a network device) to execute the method according to the embodiments of the present invention.

### INDUSTRIAL APPLICABILITY

The temperature threshold adapted to the current environmental temperature is determined in embodiments of the present invention, so that the terminal may perform the heat dissipation of the terminal according to different environmental temperatures. In this way, the terminal may adjust an operation parameter according to the determination of the temperature threshold in different situations to achieve good heat dissipation, thereby improving the heat dissipation performance of the terminal, and expanding the adaptability of the terminal for heat dissipation at different environmental temperatures.

## Claims

1. A heat dissipation method, applied to a terminal provided with a housing having a first region and a second region, the method comprising:
acquiring a first temperature of the first region and a second temperature of the second region, wherein the first region represents an highest temperature of the housing of the terminal, and the second temperature represents an environmental temperature of an environment of the terminal;
determining, according to the second temperature, a temperature threshold, wherein the temperature threshold is a function of the second temperature; and
adjusting, according to a difference between the first temperature and the temperature threshold, an operation parameter of the terminal when the first temperature is greater than the temperature threshold.

2. The method according to claim 1, wherein adjusting, according to the difference between the first temperature and the temperature threshold, the operation parameter of the terminal comprises:
determining, according to the difference between the first temperature and the temperature threshold, an operation parameter of a to-be-operated level, wherein the operation parameter of the to-be-operated level is a function of the difference between the first temperature and the temperature threshold; and
adjusting the operation parameter of the terminal to the operation parameter of the to-be-operated level.

3. The method according to claim 1, wherein after adjusting, according to the difference between the first temperature and the temperature threshold, the operation parameter of the terminal, the method further comprises:
repeating the steps of acquiring, determining and adjusting after a preset time.

4. The method according to claim 1, wherein acquiring the first temperature acquired by a first temperature collector comprises:
acquiring at least two first candidate temperatures of the terminal; and
taking a maximum of the at least two first candidate temperatures as the first temperature.

5. The method according to claim 2, wherein the operation parameter of the to-be-operated level comprises at least one of:
a to-be-operated charging current value , to-be-operated backlight brightness to be operated and a first to-be-operated parameter,
wherein the first to-be-operated parameter comprises to-be-operated radio-frequency power, a to-be-operated working frequency of a Central Processing Unit (CPU) and a to-be-operated working frequency of a Graphic Processing Unit (GPU).

6. The method according to claim1, wherein the function of the temperature threshold and the second temperature is set based on user behaviors.

7. The method of any one of claims 1 to 6, wherein the first temperature is captured by a first temperature collector disposed in the first region and the second temperature is captured by a second temperature collector disposed in the second region.

8. A terminal, comprising:
a housing;
a first temperature collector disposed in a first region of the housing;
a second temperature collector disposed in a second region of the housing; and
a control chip connected to the first temperature collector and the second temperature collector,
wherein the first temperature collector is configured to acquire a first temperature for representing a highest temperature of the housing of the terminal;
the second temperature collector is configured to acquire a second temperature for representing an environmental temperature of an environment of the terminal; and
the control chip is configured to: determine, according to the second temperature, a temperature threshold; adjusting, according to a difference between the first temperature and the temperature threshold, an operation parameter of the terminal; wherein the temperature threshold is a function of the second temperature.

9. The terminal according to claim 8, wherein the first region comprises a middle position of an inner side of the housing of the terminal, the second region comprises an edge position of the inner side of the housing of the terminal, wherein the middle position and the edge position of the inner side of the housing of the terminal are different; the first temperature collector comprises at least two first temperature sub-collectors,
wherein each of the at least two first temperature sub-collectors is configured to collect a first candidate temperature; the first temperature collector is configured to: acquire at least two first candidate temperatures captured by the at least two first temperature sub-collectors; and take a maximum of the at least two first candidate temperatures as the first temperature.

10. The terminal according to claim 8, wherein each of the first temperature collector and the second temperature collector comprise a thermal sensor, the thermal sensor comprises a thermistor and a flexible printed circuit, wherein the flexible printed circuit and the thermistor are connected to the control chip.

11. The terminal according to claim 10, wherein the terminal further comprises an analog-to-digital converter connected between the flexible circuit board and the control chip.
